# NEUE EUROPÄISCHE PATENTSCHRIFT

(11) **EP 1 182 461 B2**
(45) Veröffentlichungstag und Bekanntmachung des Hinweises auf die Entscheidung über den Einspruch: **09.10.2019**
(45) Hinweis auf die Patenterteilung: 28.04.2010
(21) Anmeldenummer: 01202840.3
(22) Anmeldetag: 24.07.2001
(51) Int. Cl.: G01R 33/07, G01D 5/14

(54) **Sensor für die Detektion der Richtung eines Magnetfeldes**
Sensor for the detection of the direction of a magnetic field
Capteur pour la détection de la direction d'un champs magnétique

(30) Priorität: 21.08.2000 CH 20001645
(43) Veröffentlichungstag der Anmeldung: 27.02.2002
(73) Patentinhaber: Melexis Technologies NV, 3980 Tessenderlo (BE)
(72) Erfinder: Popovic, Radivoje, 1025 St-Sulpice (CH); Racz, Robert, 6300 Zug (CH); Schott, Christian, 1110 Morges (CH)
(74) Vertreter: Hohgardt, Martin

(56) Entgegenhaltungen:
- EP-A- 0 131 405
- EP-A2- 0 772 046
- EP-A2- 0 947 846
- WO-A1-98/54547
- DE-A1- 19 817 356
- DE-A1- 19 956 361
- GB-A- 2 344 424
- US-A- 3 663 843
- US-A- 5 041 780
- US-A- 5 572 058
- US-A- 5 880 586
- US-A- 5 883 567
- US-A- 6 084 401

## Beschreibung

Die Erfindung betrifft einen Sensor für die Detektion der Richtung eines Magnetfeldes der im Oberbegriff dem Anspruches 1 und 2 genannten Art.

Ein solcher Sensor eignet sich beispielsweise als Winkelsensor für die Steuerung bürstenloser Elektromotoren, die einen aus mehreren Spulen bestehenden Stator aufweisen. Der Rotor des Elektromotors weist einen Permanentmagneten auf, der mit dem Sensor zusammenwirkt zur Erzeugung eines vom Drehwinkel abhängigen Signals für die phasengerechte Ansteuerung der Spulen. Eine solche Anordnung ist aus der europäischen Patentanmeldung EP 954 085 bekannt. Als Sensor dient ein vertikales Hallelement mit mehreren Armen, wobei in jedem Arm eine von der Drehlage des Permanentmagneten abhängige Hallspannung erzeugt wird. Die Hallspannungen werden zur Ansteuerung der Spulen des Elektromotors verwendet. Das vertikale Hallelement ist empfindlich auf die parallel zur Chipoberfläche verlaufenden Komponenten des vom Permanentmagneten erzeugten Magnetfeldes. Es hat den Nachteil, dass es nicht zusammen mit der Verarbeitungselektronik auf demselben Chip realisiert werden kann, da es auf einer speziellen Halbleitertechnologie basiert.

Bekannt ist auch die Verwendung horizontaler Hallelemente, die empfindlich auf die senkrecht auf die Chipoberfläche auftreffende Komponente des vom Permanentmagneten erzeugten Magnetfeldes sind. Diese Hallelemente sind zwar mit der Verarbeitungselektronik auf demselben Chip integrierbar. Aber dieser Lösung haftet der Nachteil an, dass die Hallelemente im Bereich des Randes des Permanentmagneten angeordnet sein müssen, wo die vertikale Komponente des Magnetfeldes am grössten ist. Im Bereich der Drehachse ist die vertikale Komponente nämlich klein. Die Plazierung der Hallelemente ist abhängig von den Abmessungen des Permanentmagneten. Bei grösseren Permanentmagneten ist es dann nicht mehr wirtschaftlich, die Hallelemente auf einem einzigen Halbleiterchip zu integrieren.

Aus der europäischen Patentanmeldung EP 893 668 ist ein Winkelsensor mit einem Magnetfeldsensorelement bekannt ist, das auf dem Magnetowiderstandseffekt beruht. Um den messbaren Winkelbereich auf mehr als 180° zu erhöhen, ist zusätzlich ein horizontales Hallelement vorhanden. Das Hallelement muss aber an einer anderen Stelle als das Magnetfeldsensorelement positioniert sein, da das Magnetfeldsensorelement die horizontal verlaufenden Komponenten des Magnetfeldes das rotierenden Permanentmagneten, das Hallelement aber die vertikale Komponente das Magnetfeldes messen muss. Auf dem Magnetowiderstandseffekt beruhende Sensoren zeigen zudem Hystereseeffekte, die das Auflösungsvermögen begrenzen.

Aus der europäischen Patentanmeldung EP 772 046 ist ein Magnetfeldsensor bekannt, der empfindlich auf parallel zur Chipoberfläche gerichtete Magnetfelder ist und zusammen mit der Elektronik auf einem Halbleiterchip realisierbar ist. Mit einem solchen Magnetfeldsensor lässt sich aber nur eine einzige Komponente des Magnetfeldes messen.

Aus dem Patent US 6 084 401 ist ein Winkelsensor bekannt, der einen scheibenförmigen Magnetfeldkonzentrator und eine Vielzahl von magnetoresistiven Magnetfeldsensoren umfasst, die entlang eines Kreises um den Magnetfeldkonzentrator herum angeordnet sind. Der Magnetfeldkonzentrator wirkt mit einem als Winkelgeber eingesetzten Magneten zusammen, um ein Magnetfeld zu erzeugen, das im Bereich der Magnetfeldsensoren tangential zu den Magnetfeldsensoren und damit in deren Empfindlichkeitsrichtung verläuft.

Aus der deutschen Patentanmeldung DE 199 56 361 ist ein magnetischer Drehwinkelsensor bekannt, bei dem in einer senkrecht zur Drehachse verlaufenden Ebene eine Vielzahl von gleichartigen Magnetfeldkonzentratoren und in den Lücken zwischen den Magnetfeldkonzentratoren magnetoresistive Magnetfeldsensoren angeordnet sind.

Aus dem Patent US 5 880 586 ist ein Winkelsensor bekannt, bei dem zwei Hallelemente eingesetzt werden, um zwei Komponenten des von einem Winkelgeber erzeugten Magnetfelds zu messen.

Der Erfindung liegt die Aufgabe zugrunde, einen Sensor vorzuschlagen, der die eingangs erwähnten Nachteile nicht mehr aufweist.

Die Erfindung besteht in den im Anspruch 1 angegebenen Merkmalen. Vorteilhafte Ausgestaltungen ergeben sich aus den abhängigen Ansprüchen.

Gemäss einem ersten Aspekt der Erfindung umfasst ein Sensor für die Detektion der Richtung eines Magnetfeldes einen einzigen Magnetfeldkonzentrator mit einer flächigen Form und mindestens ein erstes Hallelement und ein zweites Hallelement oder mindestens eine erste Gruppe und eine zweite Gruppe von Hallelementen, wobei die Hallelemente im Bereich des Randes des Magnetfeldkonzentrators angeordnet sind.

Der flächige Magnetfeldkonzentrator hat die Aufgabe, ein externes Magnetfeld derart zu beeinflussen, dass es die Hallelemente in optimaler Weise durchflutet.

Die Hallelemente können sogenannte horizontale Hallelemente oder sogenannte vertikale Hallelemente sein. Horizontale Hallelemente sind empfindlich auf die Komponente des Magnetfeldes, die senkrecht auf ihre Oberfläche auftrifft, während vertikale Hallelemente empfindlich sind auf eine Komponente des Magnetfeldes, die parallel zu ihrer Oberfläche verläuft. Horizontale Hallelemente sind demzufolge unterhalb des Magnetfeldkonzentrators, vertikale Hallelemente im Bereich neben dem Rand, ausserhalb des Magnetfeldkonzentrators anzuordnen.

Gemäss einem anderen Aspekt umfasst ein Sensor für die Detektion der Richtung eines Magnetfeldes mindestens drei in einer Ebene, bezüglich eines Symmetriepunktes symmetrisch angeordnete Magnetfeldkonzentratoren, die im Bereich des Symmetriepunktes einander zugewandte Kanten aufweisen, die parallel zueinander verlaufen, und pro Magnetfeldkonzentrator ein Hallelement oder eine Gruppe von Hallelementen, wobei die Hallelemente im Bereich der parallel verlaufenden Kanten des Randes des zugehörigen Magnetfeldkonzentrators angeordnet sind.

Nachfolgend werden Ausführungsbeispiele der anhand der Zeichnung näher erläutert.

Es zeigen:
- Fig. 1,: ein erstes Beispiel eines erfindungsgemässen Sensors mit horizontalen Hall- elementen,
- Fig. 2: den Sensor in einem Schnitt entlang der Linie 1-1 in Fig. 1,
- Fig. 3: ein zweites Beispiel eines erfindungsgemässen Sensors,
- Fig. 4: Details des Sensors,
- Fig. 5, 6: ein Beispiel eines erfindungsgemässen Sensors mit vertikalen Hallelementen,
- Fig. 7a, b: Sensoren, mit denen sich die Richtung eines äusseren Magnetfeldes in drei Dimensionen bestimmen lässt, und
- Fig. 8-11: weitere Sensoren.

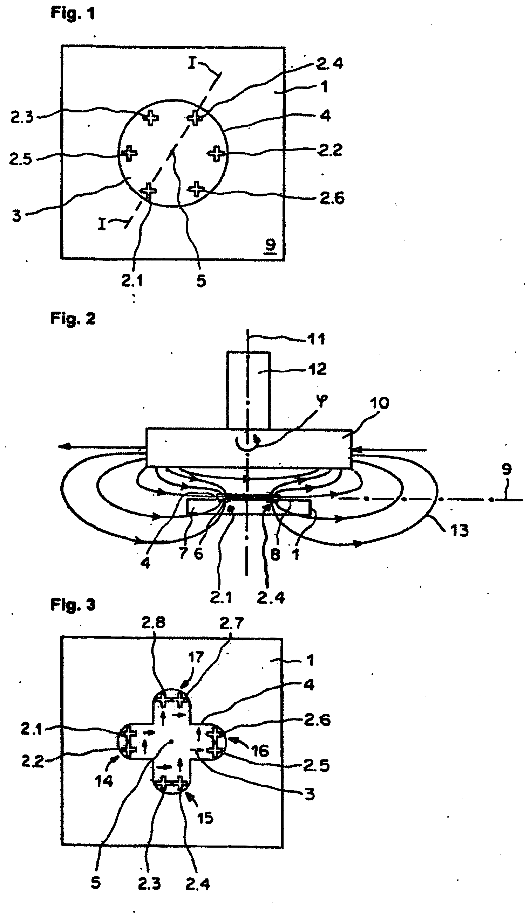

Die Fig. 1 zeigt in Aufsicht einen erfindungsgemässen Sensor, der sich z.B. als Winkelsensor für die Steuerung eines bürstenlosen Elektromotors mit drei Spulen eignet. Der Sensor umfasst einen Halbleiterchip 1 mit sechs horizontalen Hallelementen 2.1 bis 2.6 und einen einzigen Magnetfeldkonzentrator 3. Bei diesem ersten Beispiel ist der Magnetfeldkonzentrator 3 scheibenförmig ausgebildet und die sechs Hallelemente 2 sind in gleichmässigen Abständen verteilt entlang des Randes 4 des Magnetfeldkonzentrators 3 angeordnet.

Die Hallelemente 2.1 bis 2.6 sind in an sich bekannter Technologie, vorzugsweise in CMOS Technologie als n-Wanne 6 (Fig. 2) in einem p-dotierten Substrat 7 (Fig. 2) realisiert. Horizontale Hallelemente sind empfindlich auf die Komponente des Magnetfeldes, die senkrecht auf die Oberfläche 8 des Halbleiterchips 1 auftrifft. Im Beispiel haben die Hallelemente 2.1 bis 2.6 eine kreuzförmige Struktur, deren Ausrichtung vorzugsweise parallel zur 100 Kristallachse ist, damit der Einfluss veränderlicher mechanischer Spannungen auf das Hallsignal möglichst gering bleibt.

Der Magnetfeldkonzentrator 3 besteht aus ferromagnetischem Material, vorzugsweise aus Permalloy oder Mumetall oder einem Metallglas, die z.B. als Band von etwa 15µm bis 30µm Dicke erhältlich sind. Bevorzugt wird ein Metallglas mit einer vergleichsweise geringen Koerzitivfeldstärke, damit keine Hystereseeffekte auftreten. Zudem ist deren Magnetisierung weitgehend isotrop.

Der Magnetfeldkonzentrator 3 erstreckt sich in einer Ebene 9 und hat eine flächige Form, d.h. seine Dicke ist wesentlich geringer als seine Ausdehnung in der Ebene. Der Magnetfeldkonzentrator 3 weist vorzugsweise eine gleichmässige Dicke auf. Er kann aber in der Mitte dicker als am Rand ausgebildet sein. Der Magnetfeldkonzentrator 3 wirkt daher als Konzentrator für die Komponenten des Magnetfeldes, die in der Ebene 9 liegen. Die Funktion des Magnetfeldkonzentrators 3 wird anhand der Fig. 2 näher erläutert. Der Magnetfeldkonzentrator 3 weist bei diesem Beispiel ein Symmetriezentrum 5 auf, er ist nämlich rotationssymmetrisch.

Die Fig. 2 zeigt den Sensor in einem Schnitt entlang der Linie 1-1 der Fig. 1, sowie einen ein Magnetfeld erzeugenden Permanentmagneten 10, der z.B. auf der Drehachse 11 eines bürstenlosen Elektromotors 12 mit drei Spulen angebracht ist. Der Magnetfeldkonzentrator 3 verändert in seinem Umfeld den Verlauf der Feldlinien 13 des Magnetfeldes und bewirkt insbesondere, dass die Feldlinien, die bei Abwesenheit des Magnetfeldkonzentrators 3 parallel zur Oberfläche 8 des Halbleiterchips 1 verlaufen würden, das Hallelement 2.1 annähernd senkrecht zur Oberfläche 8 durchdringen. Die relative Permeabilität des Materials des Magnetfeldkonzentrators 3 ist grösser als 1000, während die relative Permeabilität von Luft und vom Halbleitersubstrat 7 etwa 1 beträgt. Die Feldlinien sind daher praktisch immer senkrecht zur Oberfläche des Magnetfeldkonzentrators 3 gerichtet. Die Hallelemente 2.1 bis 2.6 sind im Bereich des seitlichen Randes 4 des Magnetfeldkonzentrators 3 angeordnet, da die vertikale Komponente des Magnetfeldes dort am grössten ist.

Einander bezüglich des Symmetriezentrums 5 (Fig. 1) diametral gegenüberliegende Hallelemente bilden je ein Paar zur Erzeugung eines Ausgangssignals, wobei die Hallspannung des einen Hallelementes von der Hallspannung des anderen Hallelementes subtrahiert wird. Da die Feldlinien die beiden Hallelemente eines Paares in entgegengesetzter vertikaler Richtung durchdringen, addieren sich die Spannungen, die durch die "Umlenkung" des Magnetfeldes entstehen, während sich Hallspannungen, die beispielsweise aufgrund eines äusseren, die Hallelemente senkrecht durchdringenden magnetischen Störfeldes entstehen, sich gegenseitig aufheben. Zudem werden technologiebedingte Offsetspannungen mindestens teilweise kompensiert. Die Hallelemente 2.1 und 2.4 erzeugen also gemeinsam das Ausgangssignal S₁, die Hallelemente 2.2 und 2.5 erzeugen das Ausgangssignal S₂ und die Hallelemente 2.3 und 2.6 erzeugen das Ausgangssignal S₃. Die Stärke der Ausgangssignale S₁, S₂ und S₃ hängt ab von der Richtung des Magnetfeldes in der Ebene 9.

Wenn der Permanentmagnet 10 um die Drehachse 11 rotiert, dann rotiert das Magnetfeld mit und erzeugt etwa sinusförmige Ausgangssignale S₁, S₂ und S₃, die um 120° phasenverschoben sind. Das Ausgangssignal S₁ ist immer dann maximal, wenn die Richtung des Magnetfeldes des Permanentmagneten 10 parallel zur Achse ist, die die beiden Hallelemente 2.1 und 2.4 verbindet, das Ausgangssignal S₂ ist immer dann maximal, wenn die Richtung des Magnetfeldes des Permanentmagneten 10 parallel zur Achse ist, die die beiden Hallelemente 2.3 und 2.5 verbindet, etc. Die Ausgangssignale S₁, S₂ und S₃ können wie in der europäischen Patentanmeldung EP 954085 beschrieben ist, zur Steuerung der drei Spulen des Elektromotors 12 verwendet werden.

Die Ausgangssignale S₁, S₂ und S₃ können aber auch zur Bestimmung des Drehwinkels ϕ der Drehachse 11 benutzt werden, wenn der Elektromotor 12 stillsteht. Hier kommt es darauf an, dass den Ausgangssignalen S₁, S₂ und S₃ möglichst keine Signale überlagert sind, die nicht vom Magnetfeld des Permanentmagneten 10 stammen. Das vorgeschlagene Beispiel mit den jeweils paarweise gekoppelten Hallelementen eignet sich hierzu besonders, da der Einfluss externer Störfelder weitgehend eliminiert und technologiebedingte Offsetspannungen weitgehend kompensiert sind. Technologiebedingte Offsetspannungen können weiter reduziert werden, wenn anstelle der einzelnen Hallelemente 2.1 bis 2.6 aus zwei oder mehreren Hallelementen bestehende Gruppen von Hallelementen verwendet werden, wobei die Stromrichtungen in den verschiedenen Hallelementen einer Gruppe unterschiedlich sind.

Ein solches Beispiel ist in der Fig. 3 dargestellt, wo vier Gruppen 14 bis 17 mit je zwei Hallelementen 2.1 bis 2.8 vorhanden sind. Einander diametral gegenüberliegende Gruppen von Hallelementen werden paarweise gekoppelt, so dass der Sensor zwei Ausgangssignale S₁ und S₂ liefert. D.h. also, dass aus den Hallspannungen der Hallelemente 2.1, 2.2, 2.5, und 2.6 das Ausgangssignal S₁ gebildet und aus den Hallspannungen der Hallelemente 2.3, 2.4, 2.7 und 2.8 das Ausgangssignal S₂ gebildet wird. In der Fig. 3 sind die Hallelemente kreuzförmig und jedem Hallelement ist ein Pfeil zugeordnet, der die Stromrichtung innerhalb des Hallelementes anzeigt. Bei diesem Beispiel weist der Magnetfeldkonzentrator 3 ebenfalls eine kreuzförmige Struktur auf, was zu einer gegenüber der im vorhergehenden Beispiel gezeigten kreisförmigen Struktur höheren Konzentration des Magnetfeldes am Ort der Hallelemente führt. Dieser Sensor eignet sich z.B. für die Steuerung eines Elektromotors 12 mit zwei Spulen. Bei Bedarf ist es möglich, den Wert der Ausgangssignale S₁ und S₂ in Funktion des Drehwinkels ϕ zu speichern. Da die Ausgangssignale S₁ und S₂ phasenverschoben sind, lässt sich der Drehwinkel ϕ anhand der Ausgangssignale S₁ und S₂ problemlos eindeutig bestimmen.

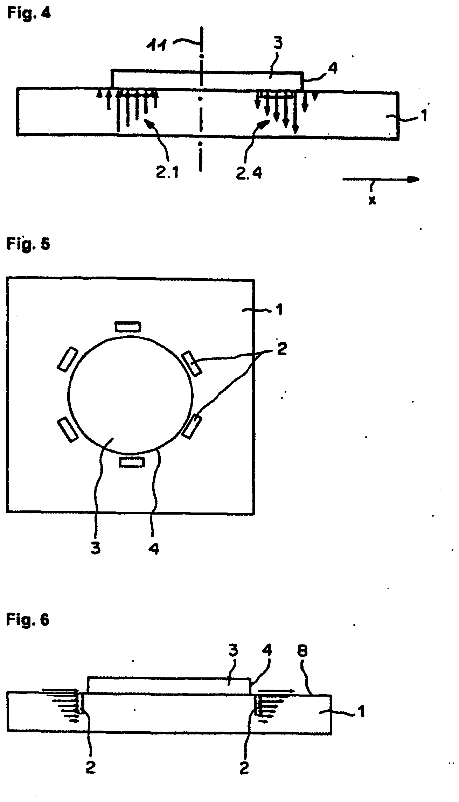

Die Fig. 4 zeigt, bezogen auf den Sensor des ersten Beispiels, in schematischer, nicht massstabsgetreuer Darstellung den Halbleiterchip 1 mit den beiden integrierten Hallelementen 2.1 und 2.4, die einander in der Ebene bezüglich der Drehachse 11 diametral gegenüberliegen (siehe auch Fig. 1), und den kreisförmigen Magnetfeldkonzentrator 3. Mit vertikalen Pfeilen sind die Stärke und Richtung des vom Permanentmagneten 10 (Fig. 2) erzeugten Feldes im Bereich der beiden Hallelemente 2.1 und 2.4 dargestellt. Eine Verschiebung des Magnetfeldkonzentrators 3 aus der idealen Position in positiver x-Richtung bewirkt eine Abnahme der Hallspannung im Hallelement 2.1 und eine Zunahme der Hallspannung im Hallelement 2.4. Vorteilhafterweise ist der Durchmesser des Magnetfeldkonzentrators 3 so auf den Abstand der beiden Hallelemente 2.1 und 2.4 abgestimmt, dass sich beide Hallelemente 2.1 und 2.4, bei idealer Lage des Magnetfeldkonzentrators 3 bezüglich der beiden Hallelemente 2.1 und 2.4, nicht innerhalb der Zone befinden, wo die Feldstärke des Magnetfeldes ihr Maximum erreicht: Die Hallelemente 2.1 und 2.4 sind entweder näher beim Zentrum, wie in der Fig. 4 gezeigt, oder entfernter vom Zentrum plaziert. Der Einfluss von Positionierungsvariationen des Magnetfeldkonzentrators 3 bezüglich der beiden Hallelemente 2.1 und 2.4 wird so minimiert.

Falls der Sensor nur zur Steuerung eines Elektromotors dient, wobei der Drehwinkel im Stillstand des Motors nicht interessiert, dann genügt es, wenn nur eines der paarweise gekoppelten Hallelemente vorhanden ist. Beim ersten Ausführungsbeispiel sind dies die Hallelemente 2.1, 2.2 und 2.3.

Anstelle eines kreisförmigen Magnetfeldkonzentrators kann auch ein Magnetfeldkonzentrator mit einer anderen, z.B. polygonalen Form, verwendet werden. Insbesondere aus photolithographischen Gründen kann es angezeigt sein, die Kreisform durch ein Vieleck anzunähern. Ebenso kann die Zahl der Hallelemente erhöht werden.

Die Fig. 5 zeigt ein Ausführungsbeispiel mit vertikalen Hallelementen 2. Vertikale Hallelemente sind empfindlich auf die Komponente des Magnetfeldes, die das Hallelement parallel zur Oberfläche 8 des Halbleiterchips 1 durchdringen. Ein mit der Elektronik integrierbares vertikales Hallelement ist beispielsweise im amerikanischen Patent US 5572058 beschrieben. Die vertikalen Hallelemente 2 sind tangential zum Rand 4 des Magnetfeldkonzentrators 3 ausgerichtet. Sie befinden sich im Bereich des Randes 4 des Magnetfeldkonzentrators 3, aber nicht unterhalb des Magnetfeldkonzentrators 3 wie die horizontalen Hallelemente, sondern seitlich versetzt ausserhalb des Magnetfeldkonzentrators 3, wo die parallel zur Oberfläche 8 des Halbleiterchips 1 verlaufenden Feldlinien 13 (Fig. 2) des Magnetfeldes am grössten sind.

Die Fig. 6 zeigt mit Pfeilen die Stärke der horizontal verlaufenden Feldlinien 13 (Fig. 2) des Magnetfeldes im Bereich der vertikalen Hallelemente 2, wobei die Länge der Pfeile proportional zur Stärke des Magnetfeldes ist.

Die Vorteile dieser Lösungen gegenüber den aus dem Stand der Technik bekannten Lösungen liegen darin, dass
a) die Position der Hallelemente bezüglich des Permanentmagneten unkritisch ist, da die Hallelemente nicht im Bereich des Randes des Permanentmagneten plaziert werden müssen, wo die vertikale Komponente des Magnetfeldes am grössten ist, sondern im Bereich der Drehachse, wo die horizontalen Komponenten am grössten sind, so dass die Plazierung des Halbleiterchips, in dem die Hallelemente integriert sind, unabhängig von der Lage des Randes des Permanentmagneten erfolgen kann.
b) der Magnetfeldkonzentrator das Magnetfeld im Bereich der Hallelemente zusätzlich verstärkt,
c) die Hallelemente und die Verarbeitungselektronik auf dem gleichen Halbleiterchip integrierbar sind, und
d) eine in den üblichen Fertigungstoleranzen liegende Abweichung der Ist-Lage des Magnetfeldkonzentrators von seiner Soll-Lage kaum Einfluss auf die erzeugten Signale hat.

Die beschriebenen Sensoren eignen sich auch als Winkelsensor für die in der eingangs zitierten europäischen Patentanmeldung EP 893 668 beschriebenen Anwendungen.

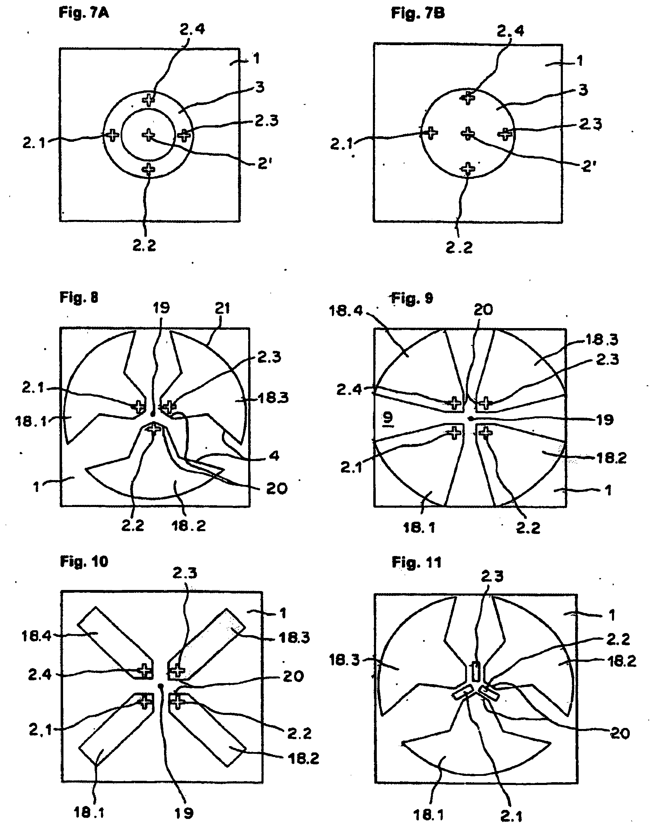

Die Fig. 7a zeigt ein Beispiel eines Sensors, bei dem der Magnetfeldkonzentrator 3 die Form eines Kreisringes aufweist. Dies erlaubt die Anordnung eines weiteren horizontalen Hallelementes 2', beispielsweise im Zentrum des Kreisringes, mit dem die senkrecht auf das Hallelement 2' auftreffende Komponente des Magnetfeldes gemessen werden kann. Ein solcher Sensor eignet sich z.B. für die Verwendung in einem Joystick, da sich damit die Richtung eines äusseren Magnetfeldes in drei Dimensionen bestimmen lässt.

Da der Magnetfeldkonzentrator 3 sehr dünn ist, beeinflusst er die senkrecht auf das Hallelement 2' auftreffende Komponente des Magnetfeldes praktisch nicht. Auch mit dem in der Fig. 7b dargestellten Sensor lässt sich die Richtung eines äusseren Magnetfeldes in drei Dimensionen bestimmen. Allerdings besteht hier die Gefahr, dass sich der vertikalen Komponente horizontale Komponenten überlagern, weil der Magnetfeldkonzentrator 3 erstens die horizontalen Komponenten verstärkt und zweitens bei Abweichungen des Magnetfeldkonzentrators 3 von seiner Soll-Lage auch horizontale Komponenten des Magnetfeldes das Hallelement 2' in senkrechter Richtung durchdringen könnten.

Anzumerken ist jedoch, dass beim Beispiel nach Fig. 7a der Magnetfeldkonzentrator 3 auch für die vertikale Komponente des Magnetfeldes als Konzentrator wirken kann, nämlich dann, wenn die Breite des ferromagnetischen Kreisringes vergleichbar mit seiner Dicke ist. Aus der Summe der Signale der beiden Hallelemente 2.1 und 2.3 oder der Summe der Signale der beiden Hallelemente 2.2 und 2.4 lässt sich ein Signal gewinnen, das proportional zur vertikalen Komponente des Magnetfeldes ist, während sich aus den Differenzen, wie oben dargelegt, die horizontalen Komponenten des Magnetfeldes bestimmen lassen. Das Hallelement 2' kann dann sogar entfallen.

Ein einzelnes Hallelement beansprucht eine relativ kleine Fläche von typischerweise einigen zehn * einigen zehn Mikrometern. Der Durchmesser des kreisförmigen Magnetfeldkonzentrators beträgt etwa 0.2 mm bis 0.5 mm. Im Idealfall ist der Durchmesser des Magnet-feldkonzentrators geringer als der Durchmesser des Permanentmagneten, der typischerweise 1.3 mm oder mehr beträgt.

Typischerweise führt ein äusseres Feld ab 20 mT im Magnetfeldkonzentrator zu Sättigungseffekten. Wenn der Soll-Abstand zwischen dem Permanentmagneten und dem Sensor so gewählt wird, dass der Magnetfeldkonzentrator mindestens teilweise magnetisch gesättigt ist, dann hat dies den Vorteil, dass die Ausgangssignale S₁, S₂, etc. nicht oder nur wenig von Abstandsschwankungen des Permanentmagneten vom Sensor abhängen.

Es ist auch möglich, die Hallelemente als Impulsgeber zu betreiben, wobei der rotierende Permanentmagnet pro Umdrehung so viele Impulse erzeugt, wie Hallelemente vorhanden sind.

Die Fig. 8 zeigt einen Winkelsensor mit drei Magnetfeldkonzentratoren 18.1, 18.2 und 18.3, der sich wie der Sensor des ersten Beispiels zusammen mit einem als Winkelgeber wirkenden Permanentmagneten als Winkelsensor zur Steuerung eines drei Spulen aufweisenden Elektromotors eignet. Die Magnetfeldkonzentratoren 18.1, 18.2 und 18.3 sind symmetrisch bezüglich eines Symmetriepunktes 19 angeordnet, nämlich mit einer 120° Rotationssymmetrie. Im Bereich des dem Symmetriepunkt 19 zugewandten Randes 4 eines jeden Magnetfeldkonzentrators befindet sich ein horizontales Hallelement 2.1, 2.2 bzw. 2.3. Der Rand 4 der Magnetfeldkonzentratoren ist unterteilt in zwei Bereiche, nämlich einen inneren Bereich, wo einander gegenüberliegende Kanten 20 der Magnetfeldkonzentratoren 18.1, 18.2 und 18.3 parallel verlaufen, damit die Dichte der Feldlinien des Magnetfeldes im Spalt zwischen den beiden Kanten 20 möglichst homogen ist und eine Sättigung der Spitzen vermieden wird, und einen äusseren Bereich, wo der Abstand zwischen benachbarten Magnetfeldkonzentratoren viel grösser ist, um zu vermeiden, dass das Magnetfeld hier "kurzgeschlossen" wird. Der äussere Rand 21 der Magnetfeldkonzentratoren 18.1, 18.2 und 18.3 erstreckt sich über einen möglichst grossen Winkelbereich, um das äussere Magnetfeld möglichst effizient im Bereich der Hallelemente 2.1, 2.2 bzw. 2.3 zu konzentrieren und um Sättigungsspitzen zu vermeiden, welche die Winkelabhängigkeit der Signale beeinflussen. Bei diesem Beispiel liefert jedes Hallelement 2.1, 2.2 bzw. 2.3 ein Ausgangssignal S₁ S₂ bzw. S₃.

Anstelle der einzelnen Hallelemente 2.1, 2.2 bzw. 2.3 können auch Gruppen von Hallelementen vorgesehen sein, die untereinander bereits offsetkorrigiert sind.

Die Fig. 9 und 10 zeigen zwei weitere Sensoren mit vier Magnetfeldkonzentratoren 18.1 bis 18.4, mit denen sich die Richtung eines Magnetfeldes in zwei räumlichen Dimensionen bestimmen lassen. Hier sind je zwei einander bezüglich des Symmetriepunktes 19 diametral gegenüberliegende Hallelemente zu einem Paar gekoppelt: Die Hallelemente 2.1 und 2.3 erzeugen gemeinsam das Ausgangssignal S₁, die Hallelemente 2.2 und 2.4 erzeugen gemeinsam das Ausgangssignal S₂. Aus den Ausgangssignalen S₁ und S₂ lässt sich die Richtung des Magnetfeldes in der Ebene 9 des Sensors bestimmen.

Bei den in den Fig. 8 bis 10 gezeigten Sensoren müssen die Magnetfeldkonzentratoren nicht flächig ausgebildet sein. Sie können gegen den Rand dicker ausgebildet oder an zusätzliche externe Magnetfeldkonzentratoren angekoppelt sein, um das Magnetfeld im Bereich der Hallelemente möglichst effizient zu konzentrieren.

Die Fig. 11 zeigt ein Ausführungsbeispiel mit drei Magnetfeldkonzentratoren 18.1, 18.2, 18.3 und drei vertikalen Hallelementen 2.1, 2.2, 2.3, die jeweils in der Mitte zwischen den parallel verlaufenden Kanten 20 benachbarter Magnetfeldkonzentratoren 18.1, 18.2, 18.3 angeordnet sind.

Während Ausführungsbeispiele und Anwendungen dieser Erfindung gezeigt und beschrieben wurden, ist es für die Fachleute offenbar, dass im Lichte dieser Ausführungen viele weitere Modifikationen als die vorgängig erläuterten möglich sind, ohne vom erfinderischen Konzept abzuweichen. Die Erfindung ist daher nicht einzuschränken, ausgenommen im Sinne der Ansprüche.

## Patentansprüche

1. Sensor für die Detektion der Richtung eines Magnetfeldes, umfassend:
- einen Halbleiterchip (1),
- mindestens ein erstes Hallelement (2.1) und ein zweites Hallelement (2.2) oder mindestens eine erste Gruppe (14) von Hallelementen (2.1, 2.2) und eine zweite Gruppe (15) von Hallelementen (2.3, 2.4), und
- einen einzigen, auf einer Oberfläche (8) des Halbleiterchips (1) angeordneten scheibenförmigen Magnetfeldkonzentrator (3) mit einer flächigen Form und einem Symmetriezentrum (5), wobei der Magnetfeldkonzentrator (3) aus ferromagnetischen Material besteht und
die Hallelemente horizontale Hallelemente sind, die an der genannten Oberfläche (8) im Halbleiterchip (1) integriert und im Bereich des Randes (4) des Magnetfeldkonzentrators (3) unterhalb des Magnetfeldkonzentrators (3) auf der dem Symmetriezentrum (5) des Magnetfeldkonzentrators (3) zugewandten Seite des Randes (4) des Magnetfeldkonzentrators (3) angeordnet sind, wo sie von Feldlinien des Magnetfelds durchflutet werden, die im Bereich des Randes des Magnelfeldkonzentrators annähernd senkrecht zu der genannten Oberfläche des Halbleiterchips (1) verlaufen, so dass Feldlinien des Magnetfelds, die bei Abwesenheit des Magnetfeldkonzentrators (3) parallel zu der genannten Oberfläche (8) des Halbleiterchips (1) verlaufen würden, die Hallelemente (2) annähernd senkrecht zu der genannten Oberfläche (8) des Halbleiterchips (1) durchdringen, wobeiein drittes Hallelement (2.3) und ein viertes Hallelement (2.4) oder eine dritte Gruppe (16) von Hallelementen (2.5, 2.6) und eine vierte Gruppe (1.7) von Hallelementen (2.7, 2.8) vorhanden sind, wobei die Hallelemente im Bereich des Randes (4) des Magnetfeldkonzentrators (3) angeordnet sind,
dass das erste Hallelement (2.1) und das dritte Hallelement (2.3) bzw. die erste Gruppe (14) von Hallelementen (2.1, 2.2) und die dritte Gruppe (16) von Hallelementen (2.5, 2.6) symmetrisch bezüglich des Symmetriezentrums (5) angeordnet sind und
dass die Hallspannung des ersten Hallelements (2.1) von der Hallspannung des dritten Hallelements (2.3) bzw. die Hallspannungen der ersten Gruppe (14) von Hallelementen (2.1, 2.2) von den Hallspannungen der dritten Gruppe (16) von Hallelementen (2.5, 2.6) subtrahiert wird, und
dass das zweite Hallelement (2.2) und das vierte Hallelement (2.4) bzw. die zweite Gruppe (15) von Hallelementen (2.3, 2.4) und die vierte Gruppe (17) von Hallelementen (2.7, 2.8) symmetrisch bezüglich des Symmetriezentrums (5) angeordnet sind und
dass die Hallspannung des zweiten Hallelements (2.2) von der Hallspannung des vierten Hallelements (2.4) bzw. die Hallspannungen der zweiten Gruppe (15) von Hallelementen (2.3, 2.4) von den Hallspannungen der vierten Gruppe (17) von Hallelementen (2.7, 2.8) subtrahiert wird.

2. Sensor für die Detektion der Richtung eines Magnetfeldes, umfassend:
- einen Halbleiterchip (1),
- mindestens ein erstes Hallelement (2.1) und ein zweites Hallelement (2.2) oder mindestens eine erste Gruppe (14) von Hallelementen (2,1, 2.2) und eine zweite Gruppe (15) von Hallelementen (2.3, 2.4), und
- einen einzigen, auf einer Oberfläche (8) des Halbleiterchips (1) angeordneten Magnetfeldkonzentrator (3) mit einer flächigen Form, wobei der Magnetfeldkonzentrator (3) aus ferromagnetischen Material besteht und als Konzentrator für diejenigen Komponenten des Magnetfeldes wirkt, die parallel zur genannten Oberfläche (8) des Halbleiterchips (1) verlaufen, und
wobei die Hallelemente vertikale Hallelemente sind die an der genannten Oberfläche (8) im Halbleiterchip (1) integriert und im Bereich des Randes (4) des Magnetfeldkonzentrators (3) ausserhalb des Randes (4) des Magnetfeldkonzentrators (3) angeordnet sind, wo sie von Feldlinien des Magnetfelds durchflutet werden, die im Bereich des Randes des Magnetfeldkonzentrators annähernd senkrecht zu der genannten Oberfläche (8) des Halbleiterchips (1) und im Bereich der Hallelemente annähernd parallel zu der genannten Oberfläche (8) des Halbleiterchips (1) verlaufen.

3. Sensor nach einem der Ansprüche 1 und 2, ***dadurch gekennzeichnet, dass*** der Magnetfeldkonzentrator (3) aus Metallglas ist.

4. Verwendung eines Sensors nach einem der Ansprüche 1 bis 3 als Winkelsensor zur Bestimmung der Drehlage eines um eine Drehachse (11) drehbaren Objektes, wobei auf der Drehachse (11) ein Permanentmagnet (10) befestigt ist, ***dadurch gekennzeichnet, dass***
der Abstand zwischen dem Sensor und dem Permanentmagneten (10) so gewählt ist, dass der Magnetfeldkonzentrator (3) magnetisch mindestens teilweise in Sättigung ist.

## Claims

1. Sensor for the detection of the direction of a magnetic field, comprising:
- a semiconductor chip (1),
- at least a first Hall element (2.1) and a second Hall element (2.2) or at least a first group (14) of Hall elements (2.1, 2.2) and a second group (15) of Hall elements (2.3, 2.4), and
- a single disk-shaped magnetic field concentrator (3) arranged on a surface (8) of the semiconductor chip (1) and having a flat shape and a symmetry center (5), wherein the magnetic field concentrator (3) consists of ferromagnetic material, and
the Hall elements are horizontal Hall elements which are integrated in the semiconductor chip (1) on said surface (8) and are arranged in the region of the edge (4) of the magnetic field concentrator (3) below the magnetic field concentrator (3) on the side of the edge (4) of the magnetic field concentrator (3) facing the symmetry centre (5) of the magnetic field concentrator (3), where they are flooded by field lines of the magnetic field, which are in the region of the edge of the magnetic field concentrator approximately perpendicular to said surface of the semiconductor chip (1), so that field lines of the magnetic field which would are parallel to said surface (8) of the semiconductor chip (1) in the absence of the magnetic field concentrator (3) penetrate the Hall elements (2) approximately perpendicular to said surface (8) of the semiconductor chip (1), wherein a third Hall element (2.3) and a fourth Hall element (2.4) or a third group (16) of Hall elements (2.5, 2.6) and a fourth group (17) of Hall elements (2.7, 2.8) are present, wherein the Hall elements are arranged in the region of the edge (4) of the magnetic field concentrator (3),
in that the first Hall element (2.1) and the third Hall element (2.3) or the first group (14) of Hall elements (2.1, 2.2) and the third group (16) of Hall elements (2.5, 2.6) are arranged symmetrically with respect to the symmetry centre (5), and
in that the Hall voltage of the first Hall element (2.1) is subtracted from the Hall voltage of the third Hall element (2.3) or the Hall voltages of the first group (14) of Hall elements (2.1, 2.2) are subtracted from the Hall voltages of the third group (16) of Hall elements (2.5, 2.6), and
in that the second Hall element (2.2) and the fourth Hall element (2.4) or the second group (15) of Hall elements (2.3, 2.4) and the fourth group (17) of Hall elements (2.7, 2.8) are arranged symmetrically with respect to the symmetry centre (5), and
in that the Hall voltage of the second Hall element (2.2) is subtracted from the Hall voltage of the fourth Hall element (2.4) or the Hall voltages of the second group (15) of Hall elements (2.3, 2.4) are subtracted from the Hall voltages of the fourth group (17) of Hall elements (2.7, 2.8).

2. Sensor for detection of the direction of a magnetic field, comprising:
- a semiconductor chip (1),
- at least a first Hall element (2.1) and a second Hall element (2.2) or at least a first group (14) of Hall elements (2.1, 2.2) and a second group (15) of Hall elements (2.3, 2.4), and
- a single magnetic field concentrator (3) with a planar shape arranged on a surface (8) of the semiconductor chip (1), the magnetic field concentrator (3) consisting of ferromagnetic material and acting as a concentrator for those components of the magnetic field which are parallel to said surface (8) of the semiconductor chip (1), and
wherein the Hall elements are vertical Hall elements which are integrated in the semiconductor chip (1) on said surface (8) and are arranged in the region of the edge (4) of the magnetic field concentrator (3) outside the edge (4) of the magnetic field concentrator (3), where they are flooded by field lines of the magnetic field which are approximately perpendicular to said surface (8) of the semiconductor chip (1) in the region of the edge of the magnetic field concentrator and approximately parallel to said surface (8) of the semiconductor chip (1) in the region of the Hall elements.

3. Sensor according to one of claims 1 and 2, **characterized in that** the magnetic field concentrator (3) is made of metal glass.

4. Use of a sensor according to one of claims 1 to 3 as an angle sensor for determining the rotational position of an object which is rotatable about an axis of rotation (11), a permanent magnet (10) being fastened to the axis of rotation (11), **characterized in that**
the distance between the sensor and the permanent magnet (10) is selected such that the magnetic field concentrator (3) is magnetically at least partially saturated.

## Revendications

1. Capteur pour la détection de la direction d'un champ magnétique, comprenant:
- une puce à semi-conducteur (1),
- au moins un premier élément à effet de Hall (2.1) et un deuxième élément à effet de Hall (2.2) ou au moins un premier groupe (14) d'éléments à effet de Hall (2.1, 2.2) et un deuxième groupe (15) d'éléments à effet de Hall (2.3, 2.4), et
- un unique concentrateur de champ magnétique (3) en forme de disque étant angencé sur une surface (8) de la puce à semi-conducteur (1) ayant une forme plane et un centre de symétrie (5), dans lequel le concentrateur de champ magnétique (3) est en matériau ferromagnétique, et les éléments à effet de Hall sont des éléments à effet de Hall horizontaux qui sont intégrés dans la puce à semi-conducteur (1) sur ladite surface (8) et sont agencés dans la région de la bordure périphérique (4) du concentrateur de champ magnétique (3) sous le concentrateur de champ magnétique (3) du côté de la bordure périphérique (4) du concentrateur de champ magnétique (3) tourné vers le centre de symétrie (5) du concentrateur de champ magnétique (3) où ils sont inondés par les lignes du champ magnétique, qui s'étendent dans la bordure périphérique du concentrateur de champ magnétique approximativement perpendiculaire à ladite surface de la puce à semi-conducteur (1), de sorte que des lignes de champ du champ magnétique qui s'étendent parallèlement à ladite surface (8) de la puce à semi-conducteur (1) en l'absence du concentrateur de champ magnétique (3) traversent les éléments à effet de Hall (2) approximativement perpendiculaire à ladite surface (8) de la puce à semi-conducteur (1), dans lequel un troisième élément à effet de Hall (2.3) et un quatrième élément à effet de Hall (2.4) ou un troisième groupe (16) d'éléments à effet de Hall (2.5, 2.6) et un quatrième groupe (17) d'éléments à effet de Hall (2.7, 2.8) sont présents, les éléments à effet de Hall étant agencés dans la region de la bordure périphérique (4) du concentrateur (3) du champ magnétique, en ce que le premier élément à effet de Hall (2.1) et le troisième élément à effet de Hall (2.3) ou le premier groupe (14) d'éléments à effet de Hall (2.1, 2.2) et le troisième groupe (16) d'éléments à effet de Hall (2.5, 2.6) sont agencés de manière symétrique par rapport au centre de symétrie (5), et en ce que la tension de Hall du premier élément à effet de Hall (2.1) est soustraite de la tension de Hall du troisième élément à effet de Hall (2.3) ou les tensions de Hall du premier groupe (14) des éléments à effet de Hall (2.1, 2.2) sont soustraites des tensions de Hall du troisième groupe (16) des éléments à effet de Hall (2.5, 2.6), et
en ce que le deuxième élément à effet de Hall (2.2) et le quatrième élément à effet de Hall (2.4) ou le deuxième groupe (15) d'éléments à effet de Hall (2.3, 2.4) et le quatrième groupe (17) d'éléments à effet de Hall (2.7, 2.8) sont agencés de manière symétrique par rapport au centre de symétrie (5), et en ce que la tension de Hall du deuxième élément à effet de Hall (2.2) est soustraite de la tension de Hall du quatrième élément à effet de Hall (2.4) ou les tensions de Hall du deuxième groupe (15) des éléments à effet de Hall (2.3, 2.4) sont soustraites des tensions de Hall du quatrième groupe (17) des éléments à effet de Hall (2.7, 2.8).

2. Capteur pour la détection de la direction d'un champ magnétique, comprenant:
- une puce à semi-conducteur (1),
- au moins un premier élément à effet de Hall (2.1) et un deuxième élément à effet de Hall (2.2) ou au moins un premier groupe (14) d'éléments à effet de Hall (2.1, 2.2) et un deuxième groupe (15) d'éléments à effet de Hall (2.3, 2.4), et
- un concentrateur de champ magnétique unique (3) ayant une forme plane étant agencé sur une surface (8) de la puce à semi-conducteur (1), dans lequel le concentrateur de champ magnétique (3) étant est en matériau ferromagnétique et agissant comme concentrateur pour les composants du champ magnétique qui sont parallèles à ladite surface (8) de la puce à semi-conducteur (1), et
dans lequel les éléments à effet de Hall sont des éléments à effet de Hall verticaux qui sont intégrés dans la puce à semi-conducteur (1) sur ladite surface (8) et sont agencés dans la région de la bordure périphérique (4) du concentrateur de champ magnétique (3) à l'extérieur de la bordure périphérique (4) du concentrateur de champ magnétique (3), où ils sont inondés par des lignes de champ du champ magnétique qui s'étendent approximativement perpendiculairement à ladite surface (8) de la puce à semi-conducteur (1) dans la région de la bordure périphérique du concentrateur de champ magnétique et approximativement parallèlement à ladite surface (8) de la puce à semi-conducteur (1) dans la région des éléments à effet de Hall.

3. Capteur selon l'une des revendications 1 et 2, **caractérisé en ce que** le concentrateur de champ magnétique (3) est constitué de verre métallique.

4. Utilisation d'un capteur selon l'une quelconque des revendications 1 à 3 comme capteur de position angulaire pour déterminer la position de rotation d'un objet pouvant tourner autour d'un axe de rotation (11), dans lequel un aimant permanent (10) est fixé sur l'axe de rotation (11), **caractérisé en ce que** la distance entre le capteur et l'aimant permanent (10) est choisie de telle sorte que le concentrateur de champ magnétique (3) est magnétiquement saturé au moins en partie.
